# EUROPEAN PATENT APPLICATION

(11) **EP 4 009 391 A1**
(43) Date of publication of application: **08.06.2022**
(21) Application number: 20850097.5
(22) Date of filing: 03.07.2020
(51) Int. Cl.: H01L 51/44, H01G 9/20

(54) **PHOTOELECTRIC CONVERSION DEVICE**

(30) Priority: 02.08.2019 JP 2019143272
(71) Applicant: Zeon Corporation, Tokyo 100-8246 (JP)
(72) Inventor: YOSHIDA Masayoshi, Tokyo 100-8246 (JP); YAMAAI Midori, Tokyo 100-8246 (JP)
(74) Representative: Fujimoto, Naho
(86) International application number: PCT/JP2020/026219
(87) International publication number: WO 2021/024662

(57) **Abstract**

A photoelectric conversion device includes: a first base plate; a second base plate disposed in opposition to the first base plate; a plurality of photoelectric conversion cells that are disposed between the first base plate and the second base plate and that each include a photoelectrode and a counter electrode disposed at a side closer than the photoelectrode to the second base plate; a first wiring structure disposed adjacently to the photoelectric conversion cells and capable of electrically connecting adjacent photoelectrode conversion cells; and a second wiring structure at least partly disposed between the counter electrode and the second base plate and capable of electrically connecting any photoelectric conversion cells among the plurality of photoelectric conversion cells.

## Description

### TECHNICAL FIELD

The present disclosure relates to a photoelectric conversion device.

### BACKGROUND

In recent years, there has been increasing demand for energy harvesting devices that are capable of generating electrical power in response to the external environment in order to enable supply of electrical power even when out at a location where a commercial power supply is not available, for example. One example of an energy harvesting device such as mentioned above is a photoelectric conversion device that can generate electricity using light energy such as sunlight.

A photoelectric conversion device typically includes a plurality of photoelectric conversion cells. For example, in the case of a photoelectric conversion device having a configuration in which a plurality of photoelectric conversion cells are connected in series, the photoelectric conversion device can supply electrical power with a higher output voltage than the output voltage of a single photoelectric conversion cell.

As one example, Patent Literature (PTL) 1 discloses a solar cell module in which a plurality of cells are electrically connected through series wiring.

### CITATION LIST

### Patent Literature

PTL 1: JP2018-82137A

### SUMMARY

### (Technical Problem)

PTL 1 discloses the electrical connection of adjacent cells through series wiring. Although the series connection of a plurality of cells through connection of adjacent cells is considered by the configuration described in PTL 1, the electrical connection of a plurality of cells in various configurations, such as connection through a combination of series connection and parallel connection, is not considered.

Accordingly, an object of the present disclosure is to solve the problem set forth above and provide a photoelectric conversion device that can simplify electrical connection of a plurality of photoelectric conversion cells in various configurations.

### (Solution to Problem)

The present disclosure aims to advantageously solve the problem set forth above, and a presently disclosed photoelectric conversion device comprises: a first base plate; a second base plate disposed in opposition to the first base plate; a plurality of photoelectric conversion cells that are disposed between the first base plate and the second base plate and that each include a photoelectrode and a counter electrode disposed at a side closer than the photoelectrode to the second base plate; a first wiring structure disposed adjacently to the photoelectric conversion cells and capable of electrically connecting adjacent photoelectrode conversion cells; and a second wiring structure at least partly disposed between the counter electrode and the second base plate and capable of electrically connecting any photoelectric conversion cells among the plurality of photoelectric conversion cells. By adopting a configuration such as set forth above, the presently disclosed photoelectric conversion device enables electrical connection of any photoelectric conversion cells among the plurality of photoelectric conversion cells through the second wiring structure. Therefore, the presently disclosed photoelectric conversion device can simplify electrical connection of a plurality of photoelectric conversion cells in various configurations.

In the presently disclosed photoelectric conversion device, the second wiring structure preferably includes: an insulating layer; and a wiring layer disposed at a side further than the insulating layer from the counter electrode. By adopting a configuration such as set forth above, any photoelectric conversion cells among the plurality of photoelectric conversion cells can be electrically connected through the wiring layer included in the second wiring structure.

In the presently disclosed photoelectric conversion device, the second wiring structure preferably includes a plurality of structures in which the insulating layer and the wiring layer overlap. By adopting a configuration such as set forth above, photoelectric conversion cells can be electrically connected without crossing even in the case of complicated connection that would result in a crossing point in a single wiring layer when connecting photoelectric conversion cells.

In the presently disclosed photoelectric conversion device, it is preferable that the insulating layer includes a first through hole directly below the counter electrode, and the counter electrode is electrically connectable to wiring in the wiring layer via a conductive resin composition disposed in the first through hole. By adopting a configuration such as set forth above, the counter electrode and wiring in the wiring layer can be electrically connected in a short distance.

In the presently disclosed photoelectric conversion device, it is preferable that the insulating layer includes a second through hole directly below the first wiring structure electrically connected to the photoelectrode, and the photoelectrode is electrically connectable to wiring in the wiring layer via the first wiring structure and a conductive resin composition disposed in the second through hole. By adopting a configuration such as set forth above, the photoelectrode and wiring in the wiring layer can be electrically connected in a short distance.

In the presently disclosed photoelectric conversion device, the wiring layer preferably includes either or both of wiring connecting the photoelectric conversion cells in series and wiring connecting the photoelectric conversion cells in parallel. By adopting a configuration such as set forth above, the photoelectric conversion device enables connection of a plurality of photoelectric conversion cells in series connection or parallel connection.

In the presently disclosed photoelectric conversion device, it is preferable that wiring in the wiring layer is at least partly disposed directly below the photoelectric conversion cells. By adopting a configuration such as set forth above, the degree of freedom of wiring in the wiring layer can be increased.

In the presently disclosed photoelectric conversion device, it is preferable that the second base plate includes an opening, and a section that is exposed from the opening among wiring in the wiring layer functions as a conduction terminal that is connectable to an external device. By adopting a configuration such as set forth above, the photoelectric conversion device can easily be electrically connected to an external device.

The presently disclosed photoelectric conversion device preferably further comprises a connector, wherein the connector is electrically connected to wiring in the wiring layer that functions as a conduction terminal. By adopting a configuration such as set forth above, the photoelectric conversion device can easily be electrically connected to an external device via the connector.

The presently disclosed photoelectric conversion device preferably further comprises a circuit element disposed in the wiring layer. By adopting a configuration such as set forth above, the photoelectric conversion device can have photoelectric conversion cells and a circuit element in an integrated configuration.

### (Advantageous Effect)

According to the present disclosure, it is possible to provide a photoelectric conversion device that can simplify electrical connection of a plurality of photoelectric conversion cells in various configurations.

### BRIEF DESCRIPTION OF THE DRAWINGS

In the accompanying drawings:
FIG. 1 is a cross-sectional view illustrating schematic structure of a photoelectric conversion device according to a first embodiment of the present disclosure;
FIG. 2 is a plan view illustrating 2-series/6-parallel connection as an example of connection of photoelectric conversion cells;
FIG. 3 is a plan view illustrating schematic structure of wiring of a photoelectric conversion device in the case of the connection illustrated in FIG. 2;
FIG. 4 is a cross-sectional view at an A1-A1 line of the photoelectric conversion device illustrated in FIG. 3;
FIG. 5 is a table presenting nominal voltages of various types of secondary batteries;
FIG. 6 illustrates 3-series/4-parallel connection as another example of connection of photoelectric conversion cells;
FIG. 7 illustrates 12-series/1-parallel connection as another example of connection of photoelectric conversion cells;
FIG. 8 illustrates another example of 12-series/1-parallel connection;
FIG. 9 illustrates schematic configuration of a photoelectric conversion device according to a second embodiment of the present disclosure;
FIG. 10 illustrates schematic configuration of a photoelectric conversion device according to a third embodiment of the present disclosure;
FIG. 11 illustrates schematic configuration of a photoelectric conversion device according to a fourth embodiment of the present disclosure;
FIG. 12 illustrates one example of configuration of a male connector illustrated in FIG. 11;
FIG. 13 illustrates schematic configuration of a photoelectric conversion device according to a fifth embodiment of the present disclosure;
FIG. 14 is a plan view illustrating schematic structure of wiring of the photoelectric conversion device according to the fifth embodiment of the present disclosure;
FIG. 15 is a cross-sectional view at an A2-A2 line of the photoelectric conversion device illustrated in FIG. 14;
FIG. 16 is a plan view illustrating schematic structure of wiring of a photoelectric conversion device according to a sixth embodiment of the present disclosure;
FIG. 17 is a cross-sectional view at an A3-A3 line of the photoelectric conversion device illustrated in FIG. 16;
FIG. 18 is a cross-sectional view at an A4-A4 line of the photoelectric conversion device illustrated in FIG. 16; and
FIG. 19 illustrates one example of circuit configuration of the photoelectric conversion device illustrated in FIG. 16.

### DETAILED DESCRIPTION

The following describes embodiments of the present disclosure with reference to the drawings. Note that parts of configuration that are common to each drawing are marked by the same reference signs.

### [First embodiment]

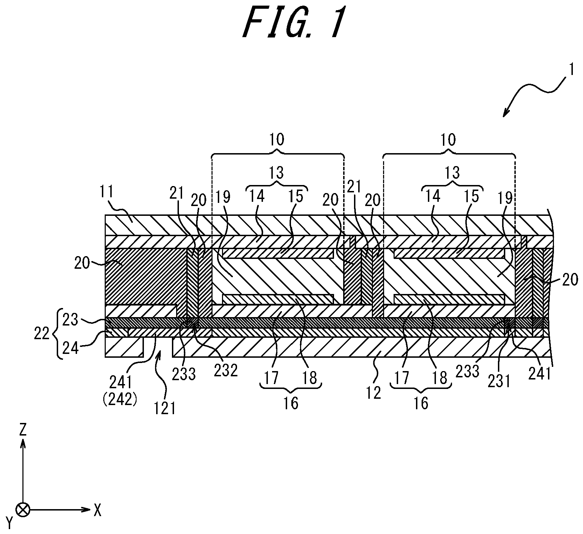

FIG. 1 is a cross-sectional view illustrating schematic structure of a photoelectric conversion device 1 according to a first embodiment of the present disclosure. The photoelectric conversion device 1 can include solar cells such as dye-sensitized solar cells, organic thin-film solar cells, or perovskite solar cells, for example, as solar cells that perform photoelectric conversion.

The photoelectric conversion device 1 includes a first base plate 11, a second base plate 12, and a plurality of photoelectric conversion cells 10. The plurality of photoelectric conversion cells 10 are disposed between the first base plate 11 and the second base plate 12. FIG. 1 illustrates two photoelectric conversion cells 10 that are disposed between the first base plate 11 and the second base plate 12. Each of the photoelectric conversion cells 10 includes a photoelectrode 13, a counter electrode 16, and an electrolyte solution 19. Moreover, the photoelectric conversion cells 10 are partitioned by partitions 20. In other words, each of the photoelectric conversion cells 10 is isolated from an adjacent photoelectric conversion cell 10 by a partition 20.

Photoelectric conversion cells that are disposed adjacently to each other can be electrically connected through a first wiring structure 21. In addition, any photoelectric conversion cells 10 among the plurality of photoelectric conversion cells 10 can be electrically connected through a second wiring structure 22. The connection of photoelectric conversion cells 10 through the first wiring structure 21 or second wiring structure 22 is described further below.

The first base plate 11 may be any commonly known light-transmitting base plate without any specific limitations. The material of the first base plate 11 may, for example, be a known transparent substrate that displays transparency in the visible region such as a transparent resin or glass. In particular, a resin that has been shaped into a film shape (i.e., a resin film) is preferably used as the material of the first base plate 11. By adopting a resin film as the material of the first base plate 11, it is possible to provide the photoelectric conversion device 1 with light weight and flexibility and thereby enable use thereof in various applications.

Examples of transparent resins that can be used to form a transparent substrate include synthetic resins such as polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), transparent polyimide (PI), and cycloolefin polymer (COP).

The second base plate 12 is disposed in opposition to the first base plate 11. The material of the second base plate 12 may be any of the same substrates as for the first base plate 11. The material of the second base plate 12 may also be a substrate that is not transparent such as a foil or plate of titanium, aluminum, or the like. A resin that has been shaped into a film shape (i.e., a resin film) is preferably used as the material of the second base plate 12 for the same reason as for the material of the first base plate 11.

The photoelectrode 13 is disposed on the first base plate 11. The photoelectrode 13 includes a transparent conductive film 14 and a porous oxide semiconductor layer 15. The transparent conductive film 14 is disposed on the first base plate 11. The porous oxide semiconductor layer 15 is disposed on the transparent conductive film 14.

The transparent conductive film 14 is separated from a transparent conductive film 14 of an adjacent photoelectric conversion cell 10 by a partition 20 such that there is not electrical conduction with the transparent conductive film 14 of the adjacent photoelectric conversion cell 10.

The transparent conductive film 14 may, for example, be formed from a conductive layer that is formed of a metal mesh made of Au, Ag, Cu, or the like. Alternatively, the transparent conductive film 14 may, for example, be formed from a conductive layer that is formed through application of metal nanoparticles such as Ag nanoparticles, fine Ag wires, or the like. Further alternatively, the transparent conductive film 14 may, for example, be formed from a conductive layer that is formed of a complex metal oxide such as indium tin oxide (ITO), indium zinc oxide (IZO), or fluorine-doped tin oxide (FTO). Further alternatively, the transparent conductive film 14 may, for example, be formed from a carbon-based conductive layer that contains carbon nanotubes, graphene, or the like. Further alternatively, the transparent conductive film 14 may, for example, be formed from a conductive layer that is formed of a conductive polymer such as PEDOT/PSS (poly(3,4-ethylenedioxythiophene) polystyrene sulfonate). A plurality of these types of conductive layers may be stacked on a substrate such as a resin or glass, or various conductive materials described above that can be used to form these conductive layers may be mixed and used to form a single conductive layer.

The method by which the transparent conductive film 14 is formed on the first base plate 11 can be a known formation method such as screen printing or a method using a combination of sputtering and etching.

The porous oxide semiconductor layer 15 may have a sensitizing dye loaded (adsorbed) thereon. In this case, the porous oxide semiconductor layer 15 may be a porous semiconductor fine particulate layer that is obtained by causing adsorption of a sensitizing dye, such as an organic dye or metal complex dye, to a porous semiconductor fine particulate layer containing particles of an oxide semiconductor, such as titanium oxide, zinc oxide, or tin oxide, for example. The organic dye may be a cyanine dye, a merocyanine dye, an oxonol dye, a xanthene dye, a squarylium dye, a polymethine dye, a coumarin dye, a riboflavin dye, a perylene dye, or the like. The metal complex dye may be a phthalocyanine complex, a porphyrin complex, or the like of a metal such as iron, copper, or ruthenium. Representative examples of sensitizing dyes include N3, N719, N749, D102, D131, D150, N205, HRS-1, HRS-2, and the like. It is preferable that an organic solvent in which the sensitizing dye is to be dissolved is subjected to degassing and purification by distillation in advance in order to remove moisture and gas present in the solvent. Preferable examples of solvents that may be used as the organic solvent include alcohols such as methanol, ethanol, and propanol, nitriles such as acetonitrile, halogenated hydrocarbons, ethers, amides, esters, carbonate esters, ketones, hydrocarbons, aromatics, and nitromethane.

The method by which the porous oxide semiconductor layer 15 is formed on the transparent conductive film 14 can be a known formation method such as screen printing or coating.

The counter electrode 16 is disposed at a side closer than the photoelectrode 13 to the second base plate 12. The counter electrode 16 is disposed in opposition to the photoelectrode 13 with the electrolyte solution 19 in-between. The counter electrode 16 includes a transparent conductive film 17 and a catalyst layer 18. The transparent conductive film 17 is disposed on an insulating layer 23 of the second wiring structure 22 described further below. The catalyst layer 18 is disposed on the transparent conductive film 17.

The transparent conductive film 17 is separated from a transparent conductive film 17 of an adjacent photoelectric conversion cell 10 by a partition 20 such that there is not electrical conduction with the transparent conductive film 17 of the adjacent photoelectric conversion cell 10.

The transparent conductive film 17 may be formed from any of the same conductive layers as for the conductive layer forming the transparent conductive film 14.

The catalyst layer 18 is disposed in opposition to the porous oxide semiconductor layer 15 with the electrolyte solution 19 in-between.

The catalyst layer 18 can be any catalyst layer that contains a component capable of functioning as a catalyst, such as a conductive polymer, a carbon nanostructure, precious metal particles, or a mixture of a carbon nanostructure and precious metal particles.

Examples of conductive polymers that may be used include polythiophenes such as poly(thiophene-2,5-diyl), poly(3-butylthiophene-2,5-diyl), poly(3-hexylthiophene-2,5-diyl), and poly(2,3-dihydrothieno-[3,4-b]-1,4-dioxine) (PEDOT); polyacetylene and derivatives thereof; polyaniline and derivatives thereof; polypyrrole and derivatives thereof; and polyphenylene vinylenes such as poly(p-xylene tetrahydrothiophenium chloride), poly[(2-methoxy-5-(2'-ethylhexyloxy))-1,4-phenylenevinylene], poly[(2-methoxy-5-(3',7'-dimethyloctyloxy)-1,4-phenylenevinylene)], and poly[2-(2',5'-bis(2"-ethylhexyloxy)phenyl)-1,4-phenylenevinylene].

Examples of carbon nanostructures that may be used include natural graphite, activated carbon, artificial graphite, graphene, carbon nanotubes, and carbon nanobuds.

The precious metal particles are not specifically limited so long as they have catalytic action and can be selected as appropriate from among commonly known precious metal particles such as metal platinum, metal palladium, and metal ruthenium.

The electrolyte solution 19 is sealed in a space surrounded by the photoelectrode 13, the counter electrode 16, and the partitions 20 in each of the photoelectric conversion cells 10. The electrolyte solution 19 may be formed from any electrolyte solution that can be used in a dye-sensitized solar cell, for example.

The partitions 20 are disposed between the first base plate 11 and the second base plate 12 and function as insulating layers. The partitions 20 can partition the photoelectric conversion cells 10. In other words, the partitions 20 can isolate each of the photoelectric conversion cells 10 from a photoelectric conversion cell 10 that is adjacent thereto.

The partitions 20 preferably have excellent adhesiveness, resistance to electrolytes (chemical resistance), and high-temperature high-humidity durability (damp heat resistance). Examples of partition materials that can form such partitions 20 include non-conductive thermoplastic resins, thermosetting resins, and activating radiation (light or electron beam) curable resins. More specifically, a (meth)acrylic resin, fluororesin, silicone resin, olefin resin, polyamide resin, or the like may be used. Note that in the present specification, "(meth)acryl" is used to indicate "acryl" or "methacryl". Of these materials, a photocurable acrylic resin is preferable from a viewpoint of handleability.

A first wiring structure 21 is disposed adjacently to photoelectric conversion cells 10. The first wiring structure 21 is electrically conductive and is capable of electrically connecting photoelectric conversion cells 10 that are adjacent to each other. The first wiring structure 21 can electrically connect a photoelectrode 13 of one photoelectric conversion cell 10 among adjacent photoelectric conversion cells 10 and a counter electrode 16 of the other photoelectric conversion cell 10 among the adjacent photoelectric conversion cells 10. With reference to FIG. 1, a first wiring structure 21 that is disposed between a photoelectric conversion cell 10 on the left side and a photoelectric conversion cell 10 on the right side is connected to a transparent conductive film 17 of the photoelectric conversion cell 10 on the left side and a transparent conductive film 14 of the photoelectric conversion cell 10 on the right side. In this manner, the first wiring structure 21 that is disposed between the photoelectric conversion cell 10 on the left side and the photoelectric conversion cell 10 on the right side electrically connects a counter electrode 16 of the photoelectric conversion cell 10 on the left side with a photoelectrode 13 of the photoelectric conversion cell 10 on the right side.

A first wiring structure 21 can also connect a photoelectrode 13 of a photoelectric conversion cell 10 to wiring 241 included in the subsequently described second wiring structure 22. FIG. 1 illustrates the appearance of electrical connection of a photoelectrode 13 of the photoelectric conversion cell 10 on the left side to wiring 241 via a first wiring structure 21 and a conductive resin composition 233.

Each of the first wiring structures 21 may, for example, be formed from a composition that contains a resin and conductive particles.

In this case, the resin may, for example, be a resin that is cured by irradiation with activating radiation or ultraviolet light or a resin that is cured by heating. Specific examples of the resin include a (meth)acrylic resin; an epoxy resin such as a bisphenol-type epoxy resin, a novolac-type epoxy resin, a cyclic epoxy resin, or an alicyclic epoxy resin; and a silicone resin. Any curing agent such as a radical initiator, a cationic curing agent, or an anionic curing agent can be used in the resin, and the form of polymerization may be addition polymerization, ring-opening polymerization, or the like, without any specific limitations.

The conductive particles can, for example, be particles formed of a metal such as Ag, Au, Cu, Al, In, Sn, Bi, or Pb or an alloy containing any of these metals, metal oxide particles, particles obtained by coating the surfaces of organic compound particles such as resin particles or inorganic compound particles with a conductive substance such as a metal or metal oxide (for example, Au/Ni alloy-coated particles), conductive carbon particles, or the like.

The second wiring structure 22 is disposed on the second base plate 12. The second wiring structure 22 is at least partly disposed between the counter electrode 16 of a photoelectric conversion cell 10 and the second base plate 12.

The second wiring structure 22 includes an insulating layer 23 and a wiring layer 24. The wiring layer 24 is disposed on the second base plate 12. The insulating layer 23 is disposed on the wiring layer 24. In other words, the wiring layer 24 is disposed at a side that is further than the insulating layer 23 from the counter electrode 16.

The insulating layer 23 includes a first through hole 231 and a second through hole 232. The first through hole 231 is a through hole that is located directly below a counter electrode 16. The second through hole 232 is a through hole that is located directly below a first wiring structure 21 that is electrically connected to a photoelectrode 13.

A conductive resin composition 233 is disposed in the first through hole 231. The counter electrode 16 is electrically connectable to wiring 241 in the wiring layer 24 via the conductive resin composition 233 disposed in the first through hole 231.

A conductive resin composition 233 is also disposed in the second through hole 232. The photoelectrode 13 is electrically connectable to wiring 241 in the wiring layer 24 via the first wiring structure 21 and the conductive resin composition 233 disposed in the second through hole 232.

First through holes 231 and second through holes 232 may be provided at locations in the insulating layer 23 that are appropriate depending on how the plurality of photoelectric conversion cells 10 are to be electrically connected.

The insulating layer 23 is a shaped product having a film shape (for example, a synthetic resin film), a sheet shape, or a thin plate shape, for example, and may be an inorganic material, a synthetic resin, or a composite material thereof. The composite material may, for example, be glass fiber-reinforced plastic. Examples of synthetic resins that can be used to form a film include epoxy resin, acrylic resin, urethane resin, ionomer resin, ethylene-acrylic acid copolymer and the like, polyimide resin, polyester resin such as polyethylene terephthalate (PET) and polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), and cycloolefin polymer (COP).

The wiring layer 24 is a layer in which wiring 241 that is electrically conductive is formed. Sections other than the wiring 241 in the wiring layer 24 are formed of an electrically insulating material.

The wiring 241 can be formed in any shape in the wiring layer 24. In this manner, the wiring 241 can electrically connect any photoelectric conversion cells 10 among the plurality of photoelectric conversion cells 10 with a high degree of freedom. The wiring 241 can connect not only photoelectric conversion cells 10 that are adjacent to each other but also photoelectric conversion cells 10 that are at distant locations. The wiring 241 can connect any photoelectric conversion cells 10 in series or in parallel.

The wiring 241 is disposed at the side corresponding to the counter electrode 16 and not at the side corresponding to the photoelectrode 13. This means that the wiring 241 does not block light that is incident on the photoelectrode 13. Accordingly, the presence of the wiring 241 has almost no effect on power generation capability of the photoelectric conversion cells 10.

The second base plate 12 includes an opening 121. A section that is exposed from the opening 121 among the wiring 241 in the wiring layer 24 functions as a conduction terminal 242 that is connectable to an external device.

The second base plate 12 includes at least two openings 121 in order to expose a conduction terminal 242 that functions as a positive electrode and a conduction terminal 242 that functions as a negative electrode. By electrically connecting an external electrical device or the like to the conduction terminal 242 that functions as a positive electrode and the conduction terminal 242 that functions as a negative electrode, it becomes possible to utilize electrical power generated by the photoelectric conversion device 1.

The second wiring structure 22 may be constructed by stacking the necessary layers on the second base plate 12. Moreover, the second wiring structure 22 may be configured as a flexible base plate, in which case, the second wiring structure 22 may be constructed by affixing the flexible base plate onto the second base plate 12. Therefore, even in a case in which the photoelectric conversion cells 10 are solar cells for which there is a thermal limitation that high heat cannot be applied during a production process, such as with plastic DSCs (Dye-sensitized Solar Cells), it is possible to apply high heat in production of the second wiring structure 22 before the second wiring structure 22 is affixed.

### (2-Series/6-parallel connection)

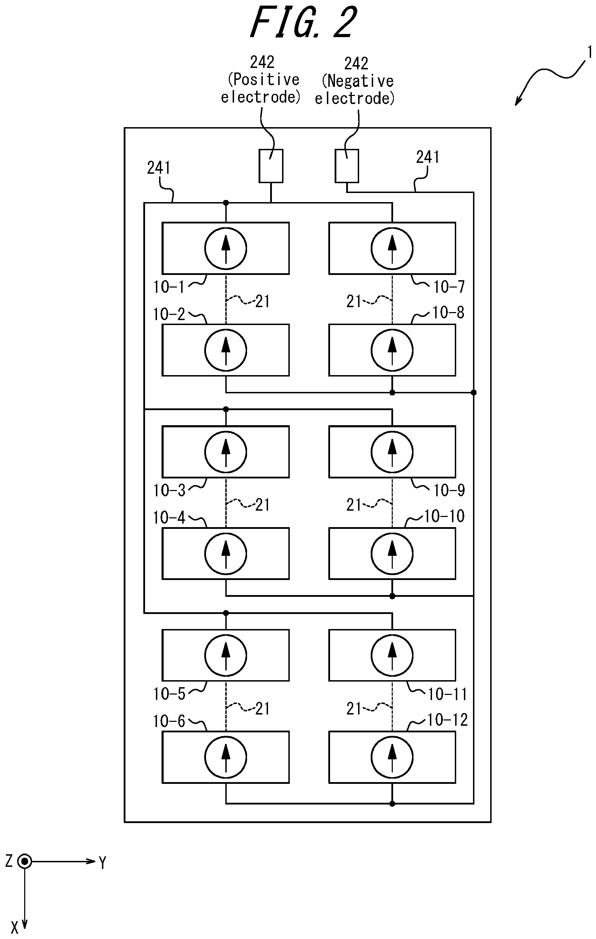

The following describes, with reference to FIGS. 2 to 4, one example of a case in which 12 photoelectric conversion cells 10 are in 2-series/6-parallel connection. Note that "2-series/6-parallel" means that 6 configurations each having 2 photoelectric conversion cells 10 connected in series are connected in parallel. When a phrase such as "X-series/Y-parallel" is used in subsequent description in the present specification, this also has a similar meaning and thus indicates that Y configurations each having X photoelectric conversion cells 10 connected in series are connected in parallel.

FIG. 2 is a plan view illustrating connection in a case in which 12 photoelectric conversion cells 10 are in 2-series/6-parallel connection. However, the number of photoelectric conversion cells 10 included in the photoelectric conversion device 1 and the connection of the photoelectric conversion cells 10 are not limited thereto. The photoelectric conversion device 1 may include any plural number of photoelectric conversion cells 10. The plurality of photoelectric conversion cells 10 included in the photoelectric conversion device 1 may be connected by any number of series connections and any number of parallel connections.

Note that FIG. 2 schematically illustrates the appearance of electrical connection of photoelectric conversion cells 10 through first wiring structures 21 and wiring 241 of a second wiring structure 22 and does not illustrate physical shape.

The arrows illustrated inside the photoelectric conversion cells 10 in FIG. 2 indicate the direction of current in the photoelectric conversion cells 10. Current flows from the counter electrode 16 toward the photoelectrode 13 in each of the photoelectric conversion cells 10.

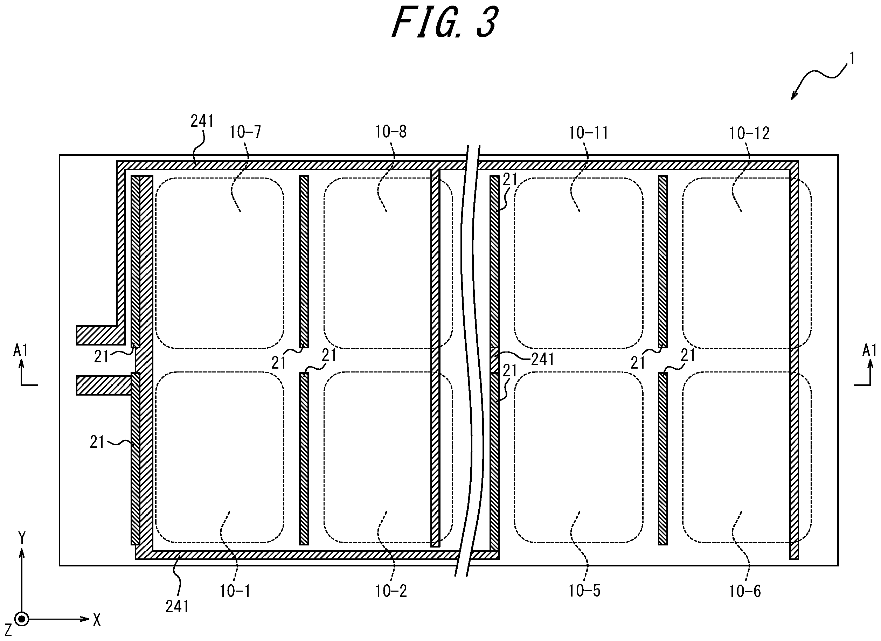

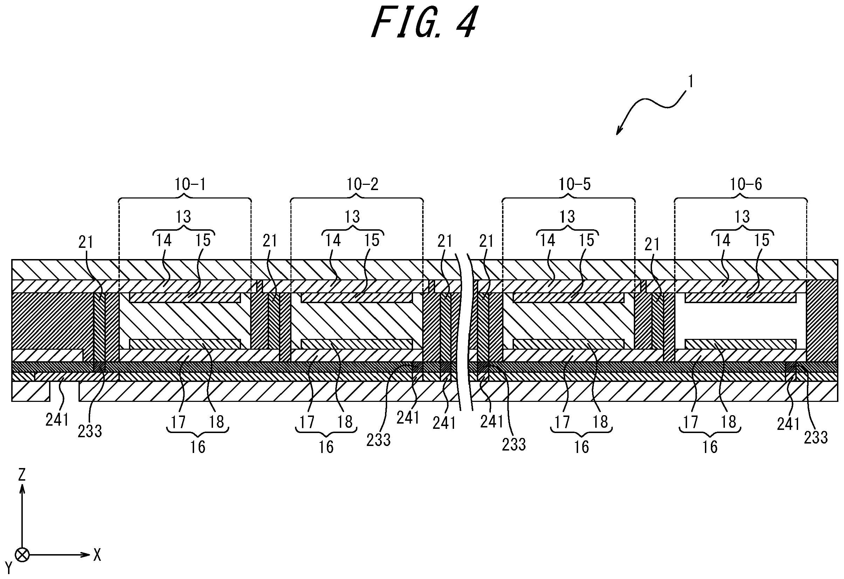

FIG. 3 is a plan view illustrating connection of photoelectric conversion cells 10 through first wiring structures 21 and wiring 241 in a case in which 12 photoelectric conversion cells 10 are in 2-series/6-parallel connection. Constituent elements of the photoelectric conversion device 1 are omitted from FIG. 3 as appropriate. FIG. 4 is a cross-sectional view at an A1-A1 line of the photoelectric conversion device 1 illustrated in FIG. 3.

In a photoelectric conversion cell 10-1 and a photoelectric conversion cell 10-2 that are adjacent photoelectric conversion cells 10 in the example of connection illustrated in FIG. 2, a counter electrode 16 of the photoelectric conversion cell 10-1 and a photoelectrode 13 of the photoelectric conversion cell 10-2 are electrically connected via a first wiring structure 21. Likewise, photoelectric conversion cells 10-3 and 10-4, photoelectric conversion cells 10-5 and 10-6, photoelectric conversion cells 10-7 and 10-8, photoelectric conversion cells 10-9 and 10-10, and photoelectric conversion cells 10-11 and 10-12 are electrically connected via first wiring structures 21. The connection through these first wiring structures 21 forms 6 configurations each having 2 photoelectric conversion cells 10 connected in series.

In order that these 6 configurations each having 2 photoelectric conversion cells 10 connected in series are connected in parallel, photoelectrodes 13 of the photoelectric conversion cells 10-1, 10-3, 10-5, 10-7, 10-9, and 10-11 are electrically connected to one another through wiring 241, and a conduction terminal 242 that functions as a positive electrode is formed on this wiring 241. Moreover, counter electrodes 16 of the photoelectric conversion cells 10-2, 10-4, 10-6, 10-8, 10-10, and 10-12 are electrically connected to one another through wiring 241, and a conduction terminal 242 that functions as a negative electrode is formed on this wiring 241.

In FIG. 2, connection by a dashed line indicates connection through a first wiring structure 21. Moreover, connection by a solid line indicates connection through wiring 241 in the second wiring structure 22. In other drawings illustrating connections between photoelectric conversion cells 10, connections by dashed lines and connections by solid lines have the same meaning as in FIG. 2.

FIG. 3 and FIG. 4 are drawings that illustrate one example in which the connections illustrated in FIG. 2 are achieved through first wiring structures 21 and wiring 241.

In FIG. 3, a photoelectrode 13 of each of the photoelectric conversion cells 10 is taken to be located at the left side of the photoelectric conversion cell 10 and a counter electrode 16 of each of the photoelectric conversion cells 10 is taken to be located at the right side of the photoelectric conversion cell 10. In this case, the photoelectrodes 13 of the photoelectric conversion cells 10-1, 10-5, 10-7, and 10-11 are connected to one another through wiring 241 in FIG. 3 (photoelectric conversion cells 10-3 and 10-9 are omitted from FIG. 3). Moreover, the counter electrodes 16 of the photoelectric conversion cells 10-2, 10-6, 10-8, and 10-12 are connected to one another through wiring 241 (photoelectric conversion cells 10-4 and 10-10 are omitted from FIG. 3).

In the photoelectric conversion cells 10-1 and 10-2, which are adjacent photoelectric conversion cells 10, the counter electrode 16 of the photoelectric conversion cell 10-1 and the photoelectrode 13 of the photoelectric conversion cell 10-2 are electrically connected via a first wiring structure 21 as seen through reference to FIG. 4. Likewise, the counter electrode 16 of the photoelectric conversion cell 10-5 and the photoelectrode 13 of the photoelectric conversion cell 10-6 are electrically connected via a first wiring structure 21.

Moreover, the photoelectrode 13 of the photoelectric conversion cell 10-1 is electrically connected to wiring 241 via a first wiring structure 21 and a conductive resin composition 233 disposed in a second through hole 232 as seen through reference to FIG. 4. The photoelectrode 13 of the photoelectric conversion cell 10-5 is electrically connected to wiring 241 through a first wiring structure 21 and a conductive resin composition 233 disposed in a second through hole 232. The wiring 241 to which the photoelectrode 13 of the photoelectric conversion cell 10-1 is connected and the wiring 241 to which the photoelectrode 13 of the photoelectric conversion cell 10-5 is connected are electrically connected through wiring 241 that extends in an X-axis direction at a negative Y-axis direction side as illustrated in FIG. 3.

Moreover, the counter electrode 16 of the photoelectric conversion cell 10-2 is electrically connected to wiring 241 via a conductive resin composition 233 disposed in a first through hole 231 as seen through reference to FIG. 4. The counter electrode 16 of the photoelectric conversion cell 10-6 is electrically connected to wiring 241 via a conductive resin composition 233 disposed in a first through hole 231. The wiring 241 to which the counter electrode 16 of the photoelectric conversion cell 10-2 is connected and the wiring 241 to which the counter electrode 16 of the photoelectric conversion cell 10-6 is connected are electrically connected through wiring 241 that extends in an X-axis direction at a positive γ-axis direction side as illustrated in FIG. 3.

Note that although FIGS. 2 and 3 illustrate a case in which the wiring 241 of the second wiring structure 22 and the photoelectric conversion cells 10 do not overlap in the Z-axis direction, the wiring 241 may be disposed at a location overlapping in the Z-axis direction with the photoelectric conversion cells 10. In such a case, the wiring 241 may be disposed at a location overlapping in the Z-axis direction with the first wiring structures 21 included in the photoelectric conversion cells 10. The arrangement of wiring 241 at a location overlapping in the Z-axis direction with the photoelectric conversion cells 10 enables size reduction of the photoelectric conversion device 1. Moreover, when the wiring 241 is also disposed at a location overlapping in the Z-axis direction with the photoelectric conversion cells 10, the degree of freedom in terms of the location at which the wiring 241 is disposed increases.

The open-circuit voltage output by a single photoelectric conversion cell 10 is approximately 0.7 V, for example. Accordingly, in the case of a 2-series/6-parallel configuration such as illustrated in FIGS. 2 to 4, the photoelectric conversion device 1 can output a voltage of approximately 1.4 V, which is 2 times 0.7 V. Such a photoelectric conversion device 1 can be used, for example, as a power supply for supplying a minute voltage.

### (Connections other than 2-series/6-parallel)

In a case in which the photoelectric conversion device 1 is to be used as a power supply for charging a secondary battery, for example, it is desirable for the photoelectric conversion device 1 to be capable of outputting a higher voltage than 1.4 V.

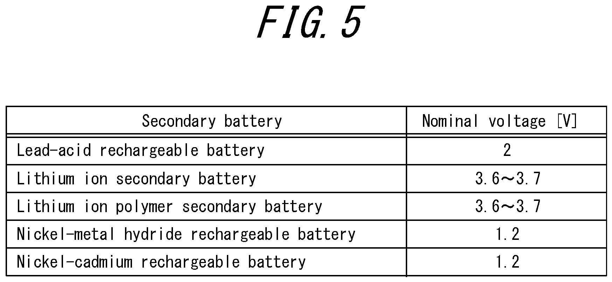

FIG. 5 is a table summarizing nominal voltages of various types of secondary batteries. Upon reference to FIG. 5, the nominal voltage of a lead-acid rechargeable battery is 2 V. The nominal voltage of a lithium ion secondary battery is 3.6 V to 3.7 V. The nominal voltage of a lithium ion polymer secondary battery is 3.6 V to 3.7 V. The nominal voltage of a nickel-metal hydride rechargeable battery is 1.2 V. The nominal voltage of a nickel-cadmium rechargeable battery is 1.2 V.

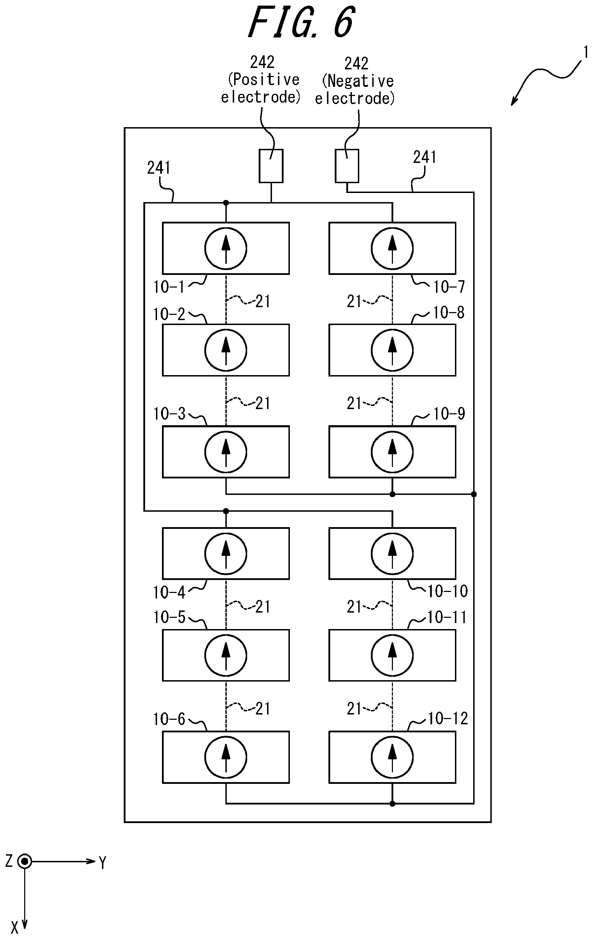

In a case in which a secondary battery such as indicated in FIG. 5 is to be charged, it is necessary for the photoelectric conversion device 1 to be capable of outputting a higher voltage than 1.4 V. The following describes photoelectric conversion devices 1 that are capable of outputting a higher voltage than 1.4 V with reference to FIGS. 6 to 8.

### <3-Series/4-parallel connection>

FIG. 6 is a plan view illustrating connection for a case in which 12 photoelectric conversion cells 10 are in 3-series/4-parallel connection.

Photoelectric conversion cells 10-1 to 10-3 that are adjacent photoelectric conversion cells 10 in the example of connection illustrated in FIG. 6 are electrically connected via first wiring structures 21. Likewise, photoelectric conversion cells 10-4 to 10-6, photoelectric conversion cells 10-7 to 10-9, and photoelectric conversion cells 10-10 to 10-12 are electrically connected via first wiring structures 21. The connection through these first wiring structures 21 forms 4 configurations each having 3 photoelectric conversion cells 10 connected in series.

Moreover, in order that the 4 configurations each having 3 photoelectric conversion cells 10 connected in series are connected in parallel, photoelectrodes 13 of the photoelectric conversion cells 10-1, 10-4, 10-7, and 10-10 are electrically connected to one another through wiring 241, and a conduction terminal 242 that functions as a positive electrode is formed on this wiring 241. In addition, counter electrodes 16 of the photoelectric conversion cells 10-3, 10-6, 10-9, and 10-12 are electrically connected to one another through wiring 241, and a conduction terminal 242 that functions as a negative electrode is formed on this wiring 241.

In the case of a 3-series/4-parallel configuration such as illustrated in FIG. 6, the photoelectric conversion device 1 can output a voltage of approximately 2.1 V, which is 3 times 0.7 V. Such a photoelectric conversion device 1 can be used, for example, as a power supply for charging the nickel-metal hydride rechargeable battery or nickel-cadmium rechargeable battery indicated in FIG. 5.

### <12-Series/1-parallel connection>

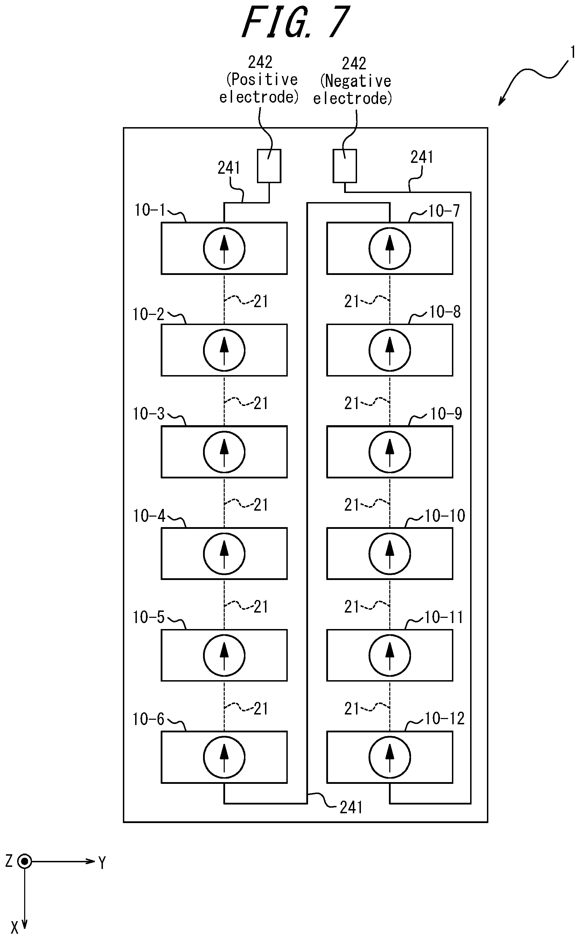

FIG. 7 is a plan view illustrating connection for a case in which 12 photoelectric conversion cells 10 are in 12-series/1-parallel connection.

Photoelectric conversion cells 10-1 to 10-6 that are adjacent photoelectric conversion cells 10 in the example of connection illustrated in FIG. 7 are electrically connected via first wiring structures 21. Likewise, photoelectric conversion cells 10-7 to 10-12 are electrically connected via first wiring structures 21. The connection through these first wiring structures 21 forms 2 configurations each having 6 photoelectric conversion cells 10 connected in series.

Moreover, in order for the 6 photoelectric conversion cells 10 connected in series to be configured as 12 photoelectric conversion cells 10 connected in series, a counter electrode 16 of the photoelectric conversion cell 10-6 and a photoelectrode 13 of the photoelectric conversion cell 10-7 are electrically connected through wiring 241. In addition, a conduction terminal 242 that functions as a positive electrode is formed on wiring 241 to which a photoelectrode 13 of the photoelectric conversion cell 10-1 is connected. Furthermore, a conduction terminal 242 that functions as a negative electrode is formed on wiring 241 to which a counter electrode 16 of the photoelectric conversion cell 10-12 is connected.

In the case of a 12-series/1-parallel configuration such as illustrated in FIG. 7, the photoelectric conversion device 1 can output a voltage of approximately 8.4 V, which is 12 times 0.7 V. Such a photoelectric conversion device 1 can be used, for example, as a power supply for charging the lead-acid rechargeable battery, lithium ion secondary battery, or lithium ion polymer secondary battery indicated in FIG. 5.

### <Other example of 12-series/1-parallel connection>

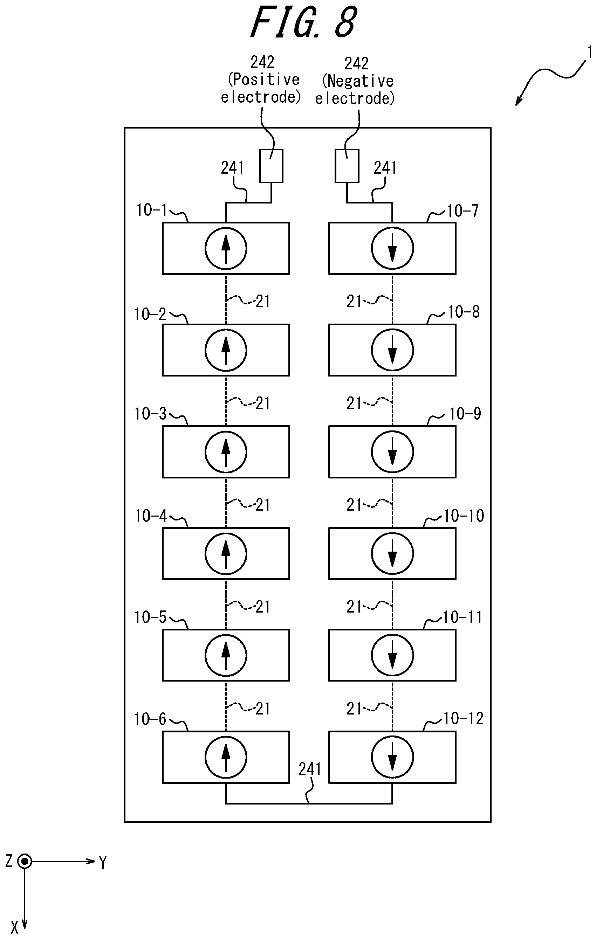

FIG. 8 is a plan view illustrating another example of connection in a case in which 12 photoelectric conversion cells 10 are in 12-series/1-parallel connection. The configuration illustrated in FIG. 8 differs from the configuration illustrated in FIG. 7 in terms that the direction of flow of current in the photoelectric conversion cells 10-7 to 10-12 is reversed relative to that in the photoelectric conversion cells 10-7 to 10-12 illustrated in FIG. 7. This can be achieved through connections of photoelectrodes 13 and counter electrodes 16 in the photoelectric conversion cells 10-7 to 10-12 being reversed relative to connections of photoelectrodes 13 and counter electrodes 16 in the photoelectric conversion cells 10-7 to 10-12 illustrated in FIG. 7. For example, a counter electrode 16 of the photoelectric conversion cell 10-7 and a photoelectrode 13 of the photoelectric conversion cell 10-8 are electrically connected via a first wiring structure 21 in the configuration illustrated in FIG. 7, whereas a photoelectrode 13 of the photoelectric conversion cell 10-7 and a counter electrode 16 of the photoelectric conversion cell 10-8 are electrically connected via a first wiring structure 21 in the configuration illustrated in FIG. 8.

Through connection such as illustrated in FIG. 8, the length of wiring 241 can be shortened compared to in the case of connection such as illustrated in FIG. 7. For example, the length of wiring 241 connecting the photoelectric conversion cell 10-6 and the photoelectric conversion cell 10-12 in the configuration illustrated in FIG. 8 is shorter than the length of wiring 241 connecting the photoelectric conversion cell 10-6 and the photoelectric conversion cell 10-7 in the configuration illustrated in FIG. 7.

As set forth above, the photoelectric conversion device 1 according to the present embodiment makes it easy to electrically connect a plurality of photoelectric conversion cells 10 in various configurations through wiring 241 in the second wiring structure 22.

### [Second embodiment]

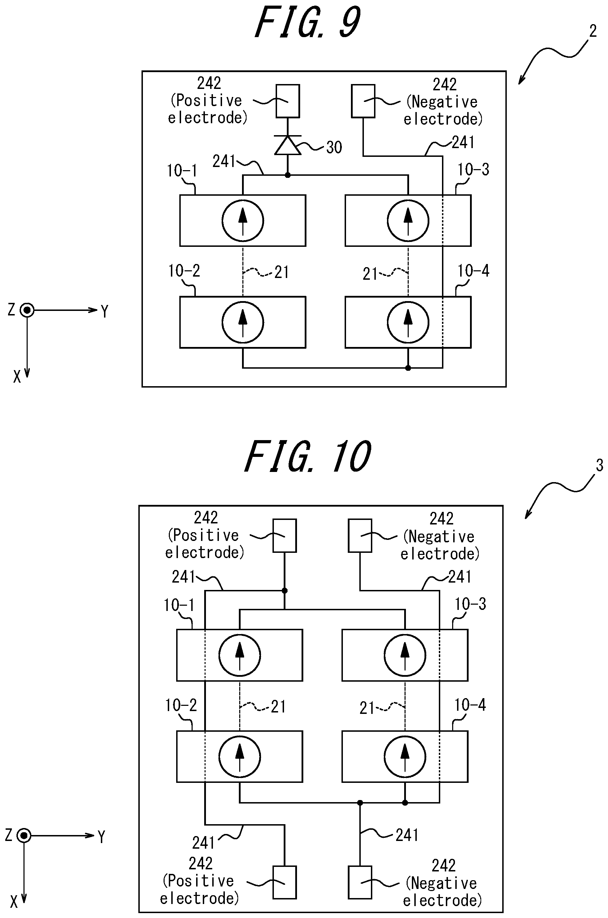

FIG. 9 is a plan view illustrating schematic configuration of a photoelectric conversion device 2 according to a second embodiment of the present disclosure. The photoelectric conversion device 2 according to the second embodiment is described focusing mainly on differences from the photoelectric conversion device 1 according to the first embodiment.

The photoelectric conversion device 2 according to the second embodiment is described using, as an example, a case in which 4 photoelectric conversion cells 10 are in 2-series/2-parallel connection. However, the number of photoelectric conversion cells 10 included in the photoelectric conversion device 2 and the connection of the photoelectric conversion cells 10 are not limited thereto. The photoelectric conversion device 2 may include any plural number of photoelectric conversion cells 10. The plurality of photoelectric conversion cells 10 included in the photoelectric conversion device 2 may be connected by any number of series connections and any number of parallel connections.

Note that FIG. 9 schematically illustrates the appearance of electrical connection of photoelectric conversion cells 10-1 to 10-4 included in the photoelectric conversion device 2 through first wiring structures 21 and wiring 241 of a second wiring structure 22 and does not illustrate physical shape.

The photoelectric conversion device 2 includes a circuit element 30 that is disposed in a wiring layer 24 of the second wiring structure 22. FIG. 9 illustrates a case in which the circuit element 30 is a diode for preventing backflow. In the example illustrated in FIG. 9, an anode of the circuit element 30 (diode) is connected to a photoelectrode 13 of the photoelectric conversion cell 10-1 and a photoelectrode 13 of the photoelectric conversion cell 10-3 through wiring 241 in the wiring layer 24. Moreover, a cathode of the circuit element 30 (diode) is connected to a conduction terminal 242 that functions as a positive electrode through wiring 241 in the wiring layer 24.

Through the circuit element 30 being disposed in the wiring layer 24 of the second wiring structure 22 in this manner, the plurality of photoelectric conversion cells 10 and the circuit element 30 can have an integrated configuration in the photoelectric conversion device 2. Consequently, size reduction and inclusion of a functional element such as a diode as a circuit element 30 can be achieved together in the photoelectric conversion device 2.

In the example illustrated in FIG. 9, wiring 241 is disposed directly below the photoelectric conversion cells 10-3 and 10-4. The arrangement of wiring 241 such as to overlap in the Z-axis direction with the photoelectric conversion cells 10 in this manner enables further size reduction of the photoelectric conversion device 2. Note that a configuration in which the photoelectric conversion cells 10 and wiring 241 overlap in the Z-axis direction such as described above can also be adopted in other sections of FIG. 9, and can also be adopted in other embodiments illustrated in other drawings such as FIG. 2, for example.

### [Third embodiment]

FIG. 10 is a plan view illustrating schematic configuration of a photoelectric conversion device 3 according to a third embodiment of the present disclosure. The photoelectric conversion device 3 according to the third embodiment is described focusing mainly on differences from the photoelectric conversion device 1 according to the first embodiment.

The photoelectric conversion device 3 according to the third embodiment is described using, as an example, a case in which 4 photoelectric conversion cells 10 are in 2-series/2-parallel connection. However, the number of photoelectric conversion cells 10 included in the photoelectric conversion device 3 and the connection of the photoelectric conversion cells 10 are not limited thereto. The photoelectric conversion device 3 may include any plural number of photoelectric conversion cells 10. The plurality of photoelectric conversion cells 10 included in the photoelectric conversion device 3 may be connected by any number of series connections and any number of parallel connections.

Note that FIG. 10 schematically illustrates the appearance of electrical connection of photoelectric conversion cells 10-1 to 10-4 included in the photoelectric conversion device 3 through first wiring structures 21 and wiring 241 of a second wiring structure 22 and does not illustrate physical shape.

The photoelectric conversion device 3 not only includes conduction terminals 242 in proximity to an edge at a negative X-axis direction side but also includes conduction terminals 242 in proximity to an edge at a positive X-axis direction side.

Through inclusion of conduction terminals 242 both in proximity to the edge at the negative X-axis direction side of the photoelectric conversion device 3 and in proximity to the edge at the positive X-axis direction side of the photoelectric conversion device 3 in this manner, it is possible to shorten wiring electrically connecting photoelectric conversion devices 3 to each other in a situation in which a plurality of photoelectric conversion devices 3 are to be electrically connected. For example, in a situation in which a plurality of photoelectric conversion devices 3 are arranged in the X-axis direction, it is possible to shorten wiring that connects conduction terminals 242 in proximity to an edge at a positive X-axis direction side of a photoelectric conversion device 3 that is located at a negative X-axis direction side and conduction terminals 242 in proximity to an edge at a negative X-axis direction side of a photoelectric conversion device 3 that is located at a positive X-axis direction side.

### [Fourth embodiment]

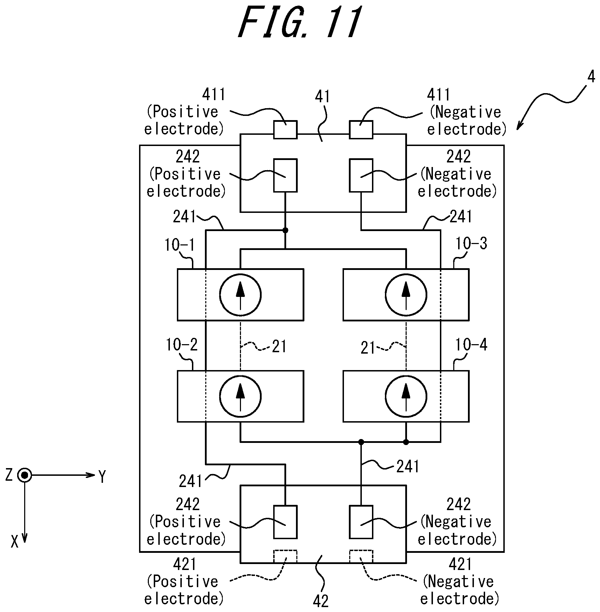

FIG. 11 is a plan view illustrating schematic configuration of a photoelectric conversion device 4 according to a fourth embodiment of the present disclosure. The photoelectric conversion device 4 according to the fourth embodiment is described focusing mainly on differences from the photoelectric conversion device 3 according to the third embodiment.

The photoelectric conversion device 4 according to the fourth embodiment is described using, as an example, a case in which 4 photoelectric conversion cells 10 are in 2-series/2-parallel connection. However, the number of photoelectric conversion cells 10 included in the photoelectric conversion device 4 and the connection of the photoelectric conversion cells 10 are not limited thereto. The photoelectric conversion device 4 may include any plural number of photoelectric conversion cells 10. The plurality of photoelectric conversion cells 10 included in the photoelectric conversion device 4 may be connected by any number of series connections and any number of parallel connections.

Note that FIG. 11 schematically illustrates the appearance of electrical connection of photoelectric conversion cells 10-1 to 10-4 included in the photoelectric conversion device 4 through first wiring structures 21 and wiring 241 of a second wiring structure 22 and does not illustrate physical shape.

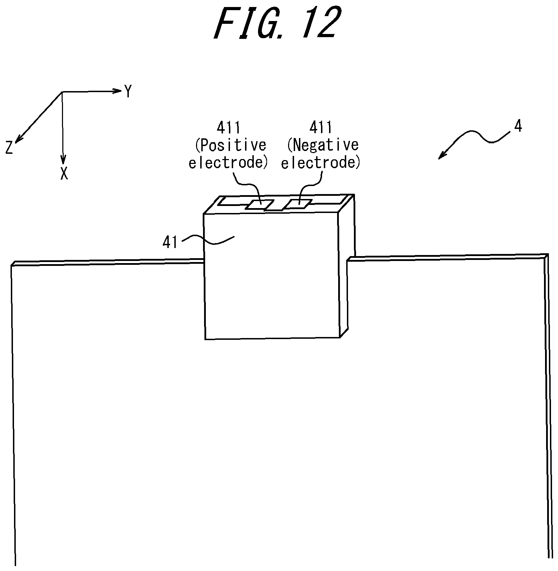

The photoelectric conversion device 4 is a device that further includes a male connector 41 and a female connector 42 in the photoelectric conversion device 3 illustrated in FIG. 10. FIG. 12 illustrates one example of configuration of the male connector 41. Illustration of the female connector 42 is omitted, but the female connector 42 may have any configuration that is mechanically and electrically connectable to the male connector 41.

The male connector 41 includes a connection terminal 411 that functions as a positive electrode and a connection terminal 411 that functions as a negative electrode. The connection terminal 411 functioning as a positive electrode is electrically connected to a conduction terminal 242 functioning as a positive electrode that is disposed at a negative X-axis direction side. The connection terminal 411 functioning as a negative electrode is electrically connected to a conduction terminal 242 functioning as a negative electrode that is disposed at the negative X-axis direction side.

The female connector 42 includes a connection terminal 421 that functions as a positive electrode and a connection terminal 421 that functions as a negative electrode. The connection terminal 421 functioning as a positive electrode is electrically connected to a conduction terminal 242 functioning as a positive electrode that is disposed at a positive X-axis direction side. The connection terminal 421 functioning as a negative electrode is electrically connected to a conduction terminal 242 functioning as a negative electrode that is disposed at the positive X-axis direction side.

As a result of the photoelectric conversion device 4 including the male connector 41 and the female connector 42 in this manner, photoelectric conversion devices 4 can be connected to each other without external wiring in a situation in which a plurality of photoelectric conversion devices 4 are to be electrically connected. For example, in a situation in which a plurality of photoelectric conversion devices 4 are arranged in the X-axis direction, photoelectric conversion devices 4 can be mechanically and electrically connected without using external wiring by inserting the male connector 41 of a photoelectric conversion device 4 located at the positive X-axis direction side into the female connector 42 of a photoelectric conversion device 4 located at the negative X-axis direction side.

Note that the arrangement of the male connector 41 and the female connector 42 illustrated in FIG. 11 is merely one example. For example, the female connector 42 may be disposed at the location of the male connector 41 illustrated in FIG. 11 and the male connector 41 may be disposed at the location of the female connector 42 illustrated in FIG. 11.

### [Fifth embodiment]

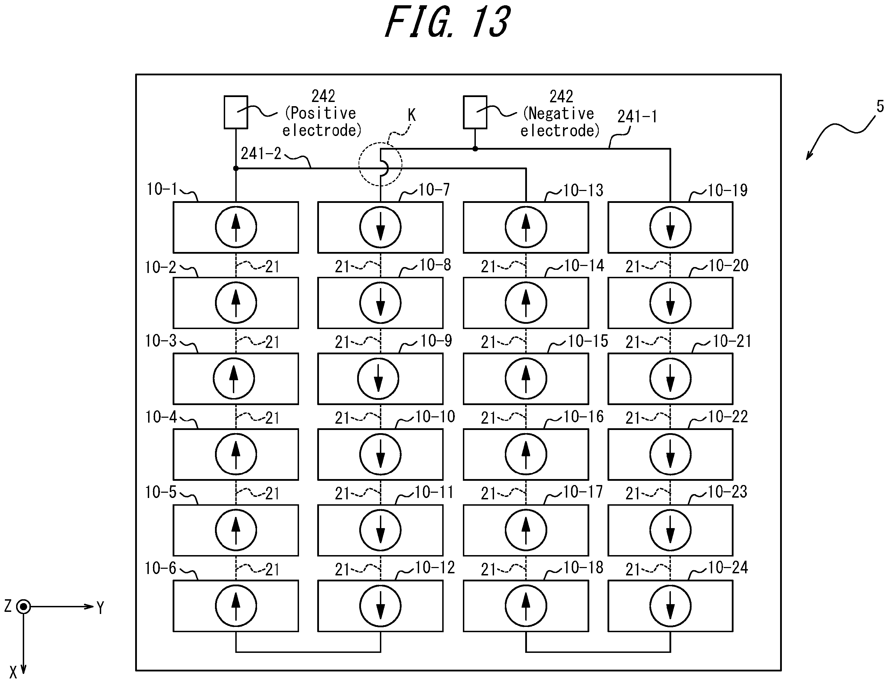

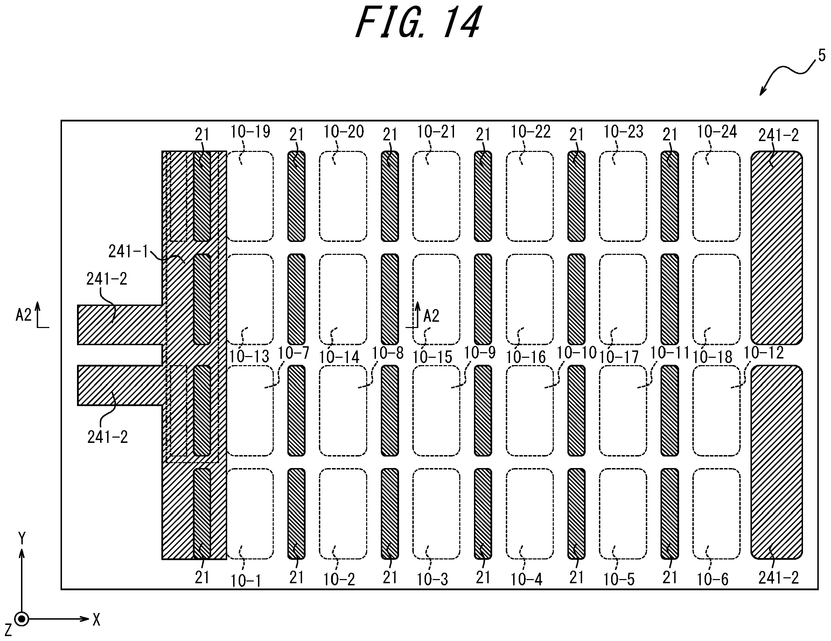

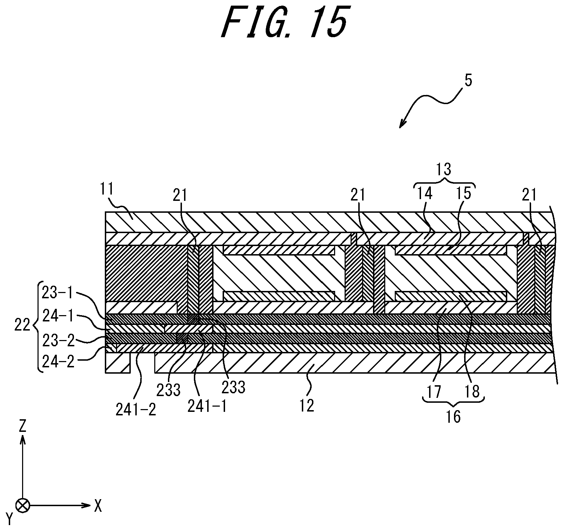

A photoelectric conversion device 5 according to a fifth embodiment of the present disclosure is described with reference to FIGS. 13 to 15. FIG. 13 is a plan view illustrating schematic configuration of the photoelectric conversion device 5 according to the fifth embodiment of the present disclosure. FIG. 14 is a cross-sectional view illustrating schematic structure of wiring of the photoelectric conversion device 5 according to the fifth embodiment of the present disclosure. FIG. 15 is a cross-sectional view at an A2-A2 line of the photoelectric conversion device 5 illustrated in FIG. 14.

The photoelectric conversion device 5 according to the fifth embodiment is described using, as an example, a case in which 24 photoelectric conversion cells 10 are in 12-series/2-parallel connection. However, the number of photoelectric conversion cells 10 included in the photoelectric conversion device 5 and the connection of the photoelectric conversion cells 10 are not limited thereto. The photoelectric conversion device 5 may include any plural number of photoelectric conversion cells 10. The plurality of photoelectric conversion cells 10 included in the photoelectric conversion device 5 may be connected by any number of series connections and any number of parallel connections.

Note that FIG. 13 schematically illustrates the appearance of electrical connection of photoelectric conversion cells 10-1 to 10-24 included in the photoelectric conversion device 5 through first wiring structures 21 and wiring 241 of a second wiring structure 22 and does not illustrate physical shape.

As illustrated in FIG. 15, the second wiring structure 22 of the photoelectric conversion device 5 includes a structure in which an insulating layer 23-1 and a wiring layer 24-1 overlap and a structure in which an insulating layer 23-2 and a wiring layer 24-2 overlap. In other words, the photoelectric conversion device 5 includes two structures in which an insulating layer 23 and a wiring layer 24 overlap.

The wiring layer 24-2 is disposed on the second base plate 12. The insulating layer 23-2 is disposed on the wiring layer 24-2. The wiring layer 24-1 is disposed on the insulating layer 23-2. The insulating layer 23-1 is disposed on the wiring layer 24-1.

The wiring layer 24-1 has wiring 241-1 that is electrically conductive formed therein. The wiring layer 24-2 has wiring 241-2 that is electrically conductive formed therein.

The wiring 241-1 in the wiring layer 24-1 can electrically connect to a first wiring structure 21 via a conductive resin composition 233 that is disposed in a through hole of the insulating layer 23-1. The wiring 241-2 in the wiring layer 24-2 can electrically connect to the wiring 241-1 in the wiring layer 24-1 via a conductive resin composition 233 disposed in a through hole of the insulating layer 23-2.

As illustrated in FIGS. 13 and 14, a photoelectrode 13 of the photoelectric conversion cell 10-1 and a photoelectrode 13 of the photoelectric conversion cell 10-13 are electrically connected via the wiring 241-2 in the wiring layer 24-2. Moreover, a counter electrode 16 of the photoelectric conversion cell 10-7 and a counter electrode 16 of the photoelectric conversion cell 10-19 are electrically connect via the wiring 241-1 in the wiring layer 24-1.

In a case in which it is necessary to connect photoelectric conversion cells 10 by a complicated connection configuration such as illustrated in FIG. 13, it may be necessary for wiring connecting the photoelectric conversion cells 10 to cross such as at crossing point K illustrated in FIG. 13, for example. As a result of the second wiring structure 22 in the photoelectric conversion device 5 according to the present embodiment including two wiring layers 24-1 and 24-2, it is possible for three-dimensional crossing of the wiring 241-1 in the wiring layer 24-1 and the wiring 241-2 in the wiring layer 24-2 to occur when a crossing point K such as illustrated in FIG. 13 is present. Consequently, the photoelectric conversion device 5 according to the present embodiment enables electrical connection of a plurality of photoelectric conversion cells 10 with a high degree of freedom even in a case in which it is necessary to connect the plurality of photoelectric conversion cells 10 in a complicated connection configuration.

Note that although a case in which the photoelectric conversion device 5 includes two structures in which an insulating layer 23 and a wiring layer 24 overlap was described as an example in the present embodiment, the photoelectric conversion device 5 may include three or more structures in which an insulating layer 23 and a wiring layer 24 overlap. In other words, the photoelectric conversion device 5 may include a plurality of structures in which an insulating layer 23 and a wiring layer 24 overlap.

### [Sixth embodiment]

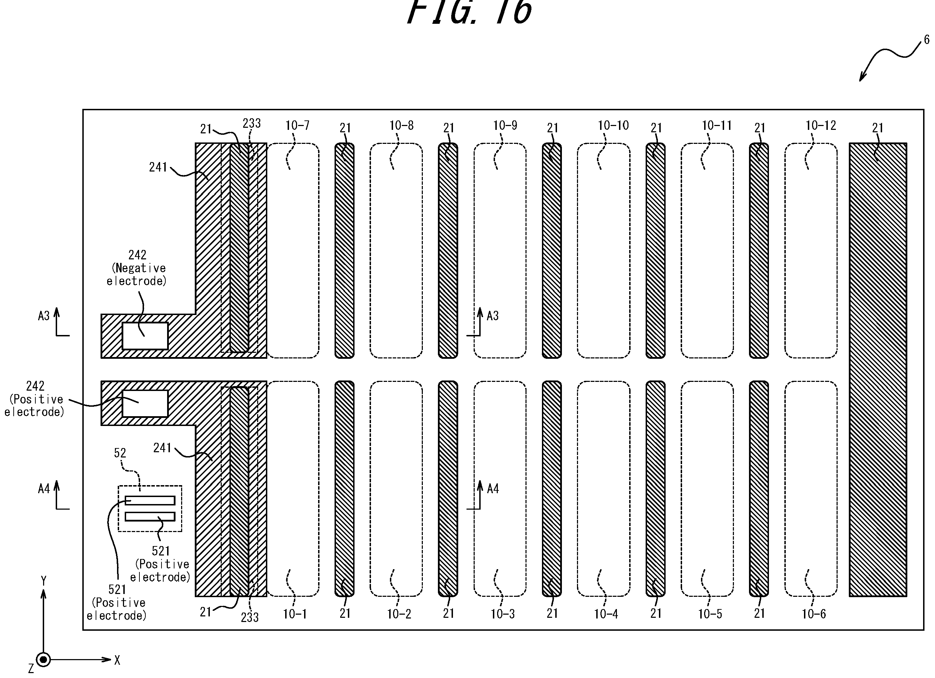

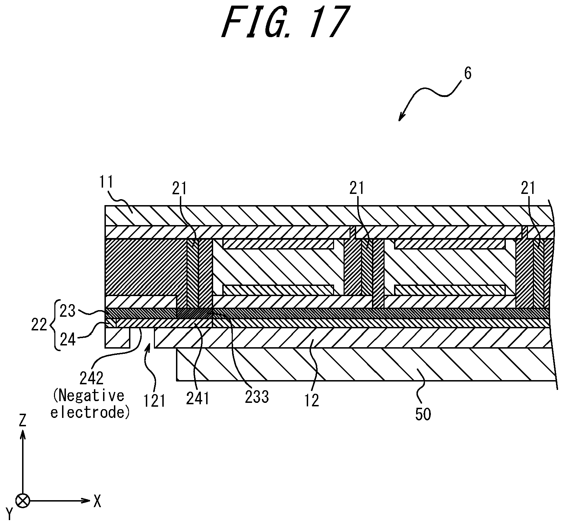

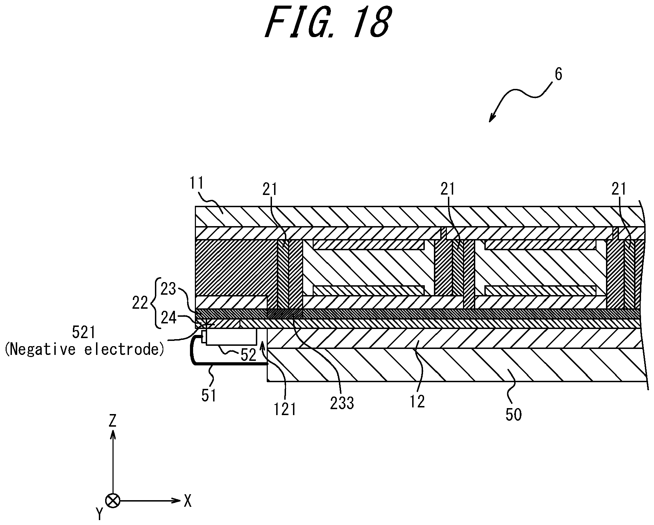

A photoelectric conversion device 6 according to a sixth embodiment of the present disclosure is described with reference to FIGS. 16 to 18. FIG. 16 is a plan view illustrating schematic structure of wiring of the photoelectric conversion device 6 according to the sixth embodiment of the present disclosure. FIG. 17 is a cross-sectional view at an A3-A3 line of the photoelectric conversion device 6 illustrated in FIG. 16. FIG. 18 is a cross-sectional view at an A4-A4 line of the photoelectric conversion device 6 illustrated in FIG. 16.

The photoelectric conversion device 6 according to the sixth embodiment is described using, as an example, a case in which 12 photoelectric conversion cells 10 are in 12-series/1-parallel connection. However, the number of photoelectric conversion cells 10 included in the photoelectric conversion device 6 and the connection of the photoelectric conversion cells 10 are not limited thereto. The photoelectric conversion device 6 may include any plural number of photoelectric conversion cells 10. The plurality of photoelectric conversion cells 10 included in the photoelectric conversion device 6 may be connected by any number of series connections and any number of parallel connections.

As illustrated in FIGS. 17 and 18, the photoelectric conversion device 6 according to the sixth embodiment has a rechargeable battery 50 disposed at a face at a negative Z-axis direction side of a second base plate 12. The rechargeable battery 50 is connected to subsequently described conduction terminals 521 through a wiring cable 51 and a connector 52 as illustrated in FIG. 18. The rechargeable battery 50 can be charged by receiving supply of electrical power generated by the photoelectric conversion cells 10 included in the photoelectric conversion device 6.

The rechargeable battery 50 may be any of the secondary batteries presented in the drawings, for example, but is not specifically limited thereto.

The connector 52 may be disposed at a location such as illustrated in FIG. 16, for example. The connector 52 is electrically connected to a conduction terminal 521 that functions as a positive electrode and a conduction terminal 521 that functions as a negative electrode. The conduction terminals 521 are sections that are electrically connected to the connector 52 among wiring 241 in a wiring layer 24.

The connector 52 may be a 2-pin type connector, for example. In this case, one of the two pins of the connector 52 is electrically connected to the conduction terminal 521 that functions as a positive electrode. The other of the two pins of the connector 52 is electrically connected to the conduction terminal 521 that functions as a negative electrode.

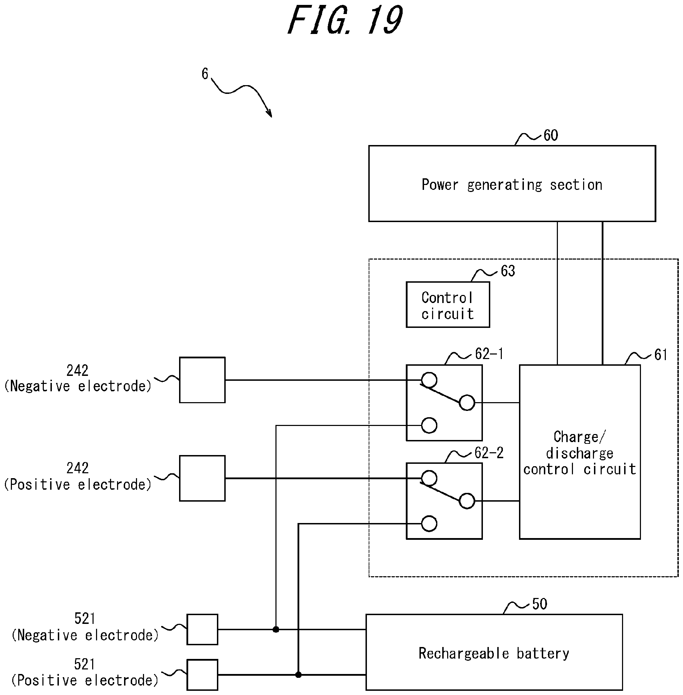

FIG. 19 illustrates one example of circuit configuration of the photoelectric conversion device 6. The circuit illustrated in FIG. 19 is an example of a case in which a charge/discharge control circuit 61, a switch 62-1, a switch 62-2, and a control circuit 63 are disposed in the wiring layer 24. The switch 62-1 and the switch 62-2 are also referred to simply as the switches 62 hereinafter when it is not necessary to distinguish between them.

A power generating section 60 illustrated in FIG. 19 indicates all of the plurality of photoelectric conversion cells 10 included in the photoelectric conversion device 6. A positive electrode and a negative electrode of the power generating section 60 are connected to the charge/discharge control circuit 61.

The charge/discharge control circuit 61 controls a voltage level and a current level such that voltage and current supplied from the power generating section 60 are adjusted to an appropriate voltage and current upon receiving a command from the control circuit 63.

The switches 62 are switches that can switch a connection destination upon receiving a command from the control circuit 63. The switch 62-1 is connected to the negative electrode of the power generating section 60 via the charge/discharge control circuit 61. The switch 62-1 switches a connection destination of the charge/discharge control circuit 61 to either the conduction terminal 242 that functions as a negative electrode or the conduction terminal 521 that functions as a negative electrode upon receiving a command from the control circuit 63. The switch 62-2 is connected to the positive electrode of the power generating section 60 via the charge/discharge control circuit 61. The switch 62-2 switches a connection destination of the charge/discharge control circuit 61 to either the conduction terminal 242 that functions as a positive electrode or the conduction terminal 521 that functions as a positive electrode upon receiving a command from the control circuit 63.

Note that it is not essential that the switch 62-1 is disposed in the wiring layer 24. In this case, the conduction terminal 242 that functions as a negative electrode and the conduction terminal 521 that functions as a negative electrode may be constantly connected to the negative electrode of the power generating section 60 via the charge/discharge control circuit 61.

The control circuit 63 controls the charge/discharge control circuit 61 and the switches 62. In a situation in which electrical power generated by the power generating section 60 is to be supplied to an external device so as to operate the external device, the control circuit 63 controls the switches 62 so that the charge/discharge control circuit 61 is connected to the conduction terminals 242. In a situation in which electrical power generated by the power generating section 60 is to charge the rechargeable battery 50, the control circuit 63 controls the switches 62 so that the charge/discharge control circuit 61 is connected to the conduction terminals 521.

In this manner, the inclusion of conduction terminals 521 that are separate to the conduction terminals 242 makes it possible for the photoelectric conversion device 6 to not only supply electrical power to an external device from the conduction terminals 242, but also to charge the rechargeable battery 50 that is integrated therewith. Moreover, by arranging functional circuits such as the charge/discharge control circuit 61, the switches 62, and the control circuit 63 in the wiring layer 24, the photoelectric conversion device 6 makes it possible to achieve a functional device in which power generation by the power generating section 60 and a specific function are integrated.

Note that although a case in which the charge/discharge control circuit 61, the switch 62-1, the switch 62-2, and the control circuit 63 are disposed in the wiring layer 24 was described as an example in FIG. 19, it is not essential that these circuits are disposed in the wiring layer 24. For example, part or all of these circuits may not be disposed in the wiring layer 24.

The preceding description merely illustrates an embodiment of the present disclosure and it goes without saying that various alterations can be made within the scope of the claims.

For example, the transparent conductive film 17 of the counter electrode 16 is not necessarily required to be transparent and may be a conductive film that is not transparent.

Moreover, although the configuration of the photoelectric conversion cells 10 was described using the case of dye-sensitized solar cells as an example, the photoelectric conversion cells 10 may be photoelectric conversion cells of a type other than dye-sensitized solar cells. For example, the photoelectric conversion cells 10 may be a type of photoelectric conversion cell that does not include an electrolyte solution 19.

### INDUSTRIAL APPLICABILITY

According to the present disclosure, it is possible to provide a photoelectric conversion device that can simplify electrical connection of a plurality of photoelectric conversion cells in various configurations.

### REFERENCE SIGNS LIST

- 1, 2, 3, 4, 5, 6: photoelectric conversion device
- 10: photoelectric conversion cell
- 11: first base plate
- 12: second base plate
- 121: opening
- 13: photoelectrode
- 14: transparent conductive film
- 15: porous oxide semiconductor layer
- 16: counter electrode
- 17: transparent conductive film
- 18: catalyst layer
- 19: electrolyte solution
- 20: partition
- 21: first wiring structure
- 22: second wiring structure
- 23: insulating layer
- 231: first through hole
- 232: second through hole
- 233: conductive resin composition
- 24: wiring layer
- 241: wiring
- 242: conduction terminal
- 30: circuit element
- 41: male connector
- 411: connection terminal
- 42: female connector
- 421: connection terminal
- 50: rechargeable battery
- 51: wiring cable
- 52: connector
- 521: conduction terminal
- 60: power generating section
- 61: charge/discharge control circuit
- 62: switch
- 63: control circuit

## Claims

1. A photoelectric conversion device comprising:
a first base plate;
a second base plate disposed in opposition to the first base plate;
a plurality of photoelectric conversion cells that are disposed between the first base plate and the second base plate and that each include a photoelectrode and a counter electrode disposed at a side closer than the photoelectrode to the second base plate;
a first wiring structure disposed adjacently to the photoelectric conversion cells and capable of electrically connecting adjacent photoelectrode conversion cells; and
a second wiring structure at least partly disposed between the counter electrode and the second base plate and capable of electrically connecting any photoelectric conversion cells among the plurality of photoelectric conversion cells.

2. The photoelectric conversion device according to claim 1, wherein the second wiring structure includes:
an insulating layer; and
a wiring layer disposed at a side further than the insulating layer from the counter electrode.

3. The photoelectric conversion device according to claim 2, wherein the second wiring structure includes a plurality of structures in which the insulating layer and the wiring layer overlap.

4. The photoelectric conversion device according to claim 2 or 3, wherein
the insulating layer includes a first through hole directly below the counter electrode, and
the counter electrode is electrically connectable to wiring in the wiring layer via a conductive resin composition disposed in the first through hole.

5. The photoelectric conversion device according to any one of claims 2 to 4, wherein
the insulating layer includes a second through hole directly below the first wiring structure electrically connected to the photoelectrode, and
the photoelectrode is electrically connectable to wiring in the wiring layer via the first wiring structure and a conductive resin composition disposed in the second through hole.

6. The photoelectric conversion device according to any one of claims 2 to 5, wherein the wiring layer includes either or both of wiring connecting the photoelectric conversion cells in series and wiring connecting the photoelectric conversion cells in parallel.

7. The photoelectric conversion device according to any one of claims 2 to 6, wherein wiring in the wiring layer is at least partly disposed directly below the photoelectric conversion cells.

8. The photoelectric conversion device according to any one of claims 2 to 7, wherein
the second base plate includes an opening, and
a section that is exposed from the opening among wiring in the wiring layer functions as a conduction terminal that is connectable to an external device.

9. The photoelectric conversion device according to claim 8, further comprising a connector, wherein the connector is electrically connected to wiring in the wiring layer that functions as a conduction terminal.

10. The photoelectric conversion device according to any one of claims 2 to 9, further comprising a circuit element disposed in the wiring layer.
